(19)

**Europäisches Patentamt**
**European Patent Office**
**Office européen des brevets**

(11) **EP 4 760 322 A1**

(12) **EUROPEAN PATENT APPLICATION**

(43) Date of publication:
**17.06.2026 Bulletin 2026/25**

(21) Application number: **24219592.3**

(22) Date of filing: **12.12.2024**

(51) International Patent Classification (IPC):
*G01R 31/62* (2020.01)

(52) Cooperative Patent Classification (CPC):
**G01R 31/62**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Hitachi Energy Ltd**
**8050 Zürich (CH)**

(72) Inventors:
• **ABEYWICKRAMA, Nilanga**
**723 51 Västerås (SE)**
• **BENGTSSON, Tord**
**723 49 Västerås (SE)**

(74) Representative: **Valea AB**
**Box 1098**
**405 23 Göteborg (SE)**

(54) **TRANSFORMER FUNDAMENTAL QUANTITY MONITORING METHOD FOR THREE-WINDING TRANSFORMERS**

(57)     The present disclosure relates to transformer diagnosis methods for a transformer having a primary side source winding and two secondary side load windings. The method using relations based on a transformer model in which effects of magnetizing currents in the transformer core, leakage inductances and effective resistances of the primary and secondary windings are taken into account, wherein a transformer model of a three-winding transformer is used; transformer currents are measured during variations of the transformer loads wherein the power transferred through the respective windings are proportional; measurements are collected, for at least two different transformer loads, of a selection of primary side currents being indicative of the transformer load; a linear fits is performed by means of relations based on said transformer model, between equivalent load current and the primary current to estimate the value of at least one of the following transformer properties: turn ratio and magnetizing current.

FIG 1

**Description**

TECHNICAL FIELD

The present disclosure relates to the field of power transformers, and in particular to on-line diagnosis of three winding transformers.

BACKGROUND

Transformers generally form an integral part of a power transmission system, providing the possibility of converting one voltage level to another and to galvanically isolate different parts of a power transmission system. Transformers in power transmission systems often represent huge investments and are typically not manufactured until ordered.

In case a transformer in a power transmission system needs to be replaced, it is often a lengthy process to get a replacement. In order to avoid situations where a transformer needs to be replaced in a rescue action, it is desirable to detect an arising problem at an early stage, so that required maintenance, or planned replacement can be performed.

Transformer on-line monitoring systems have been designed to detect and indicate, while the transformer is in operation, deviations in properties of the transformer which could indicate a deterioration of the transformer status. Examples of properties that can be monitored are temperature, combustible dissolved gas, and bushing capacitance.

The transformer impedance is a further property which has been used in transformer diagnostics. Conventionally, transformer impedance has been determined off-line, i.e. from measurements performed when the transformer was disconnected from the power transmission system.

In US2010/0188240, it is proposed to monitor the transformer impedance while the transformer is in operation. The possibility of on-line impedance monitoring would be of great benefit, since the impedance of a transformer carries useful information on the transformer status, while disconnecting a transformer from the power transmission system in order to determine the impedance is costly.

In US2010/0188240, it is proposed to obtain information on the transformer impedance by measuring the current A and the voltage E at the transformer terminals, and to generate (in a three phase system) a 9x9 impedance matrix from such measurements using the relations $E_{iH} - E_{jL} = Z_{ij}\alpha_{ij}$ and $A_{iH} = a_{i1} + \alpha_{i2} + \alpha_{i3}$, where $a_{ij}$ represent transformer terminal currents; indices H and L indicate "high voltage side" and "low voltage side", respectively; index i=1, 2, 3 indicates phases of the high voltage terminals; and index j= 1, 2, 3 indicate phases of the low voltage terminals.

As discussed in US2010/0188240, solving the equation system obtained by the proposed analysis introduces considerable computational complexity, and a simplification of the model is therefore proposed. However, even if such simplification is not employed, the accuracy of the results obtained by the proposed method will often not be sufficient for transformer diagnostic purposes.

Transformer fundamental quantity (TFQ) monitoring methods have been proposed. On-line estimation and monitoring of TFQs (impedance, turn ratio, magnetizing current and power loss) of two-winding transformers are known for example from EP2466322B1/US9322866B2.

However, two-dimensional fitting methods as the methods described in EP2466322B1/US9322866B2 would provide inferior results or is not possible to use if the relative load variation between two loaded windings is very small. For example, the known two-dimensional fit does not work for a HVDC unit with equally loaded secondary windings, or other three winding units with insignificant relative load variation between two secondaries.

Thus, the known methods do not provide secure TFQ monitoring when a three-winding transformer is driven in a specific way, for example with the same load on both secondary windings while maintaining a constant ratio between secondary voltages as is the case in HVDC transformers.

SUMMARY

A general object of embodiments herein is to provide improved and/or extended capabilities of the transformer fundamental quantity (TFQ) monitoring methods. A more particular object is to provide improved (TFQ) monitoring methods for three-winding HVDC transformers having equally loaded secondary sides.

Embodiments provides a transformer diagnosis method for a transformer having a primary side source winding and two secondary side load windings, the method using relations based on a transformer model in which effects of magnetizing currents in the transformer core, leakage inductances and effective resistances of the primary and secondary windings are taken into account, comprising: using a transformer model of a three-winding transformer having a primary side and a secondary side, said transformer being provided with two equally loaded secondary windings configured to provide a phase shift of 30° for same line-to-line voltages; measuring transformer currents during variations of the transformer loads wherein the power transferred through the respective windings are proportional; collecting, for at least two different transformer loads, measurements of a selection of primary side currents ($I_1$, $I_2$, $I_3$) being indicative of the transformer load, preferably $I_1$ and either $I_2$ or $I_3$; performing, by means of relations based on said transformer model, a first one-dimensional linear fit between equivalent load current ($I_2 + I_3/a$) and the primary current ($I_1$) to estimate the value of, or a value that is indicative of, at least one of the following transformer properties: at least one turn ratio ($n_1$, $n_2$) and the magnetizing current ($I_0$).

In embodiments, the method is performed in a transformer diagnosis apparatus comprising a processor.

In embodiments, load is imposed on the secondary windings and is varied such that the amounts of power transferred through the respective winding pair are proportional to each other in order to enable the measurement under the desired power transfer circumstances.

In embodiments, the first linear fit is based on the relations

$$ I_1 = I_0 + \frac{1}{n_1}(I_2 + \sqrt{3}I_3) \tag{5} $$

$$ I_1 = I_0 + \frac{1}{n_1}2\sqrt{3}\ I_3 \tag{5.1} $$

the turn ratios ($n_1$, $n_2$) having a proportional relation of $n_1/n_2 = \sqrt{3}$.

Embodiments may further comprise: measuring transformer voltages during variations of the transformer loads wherein the power transferred through the respective windings are proportional; collecting, for said at least two different transformer loads, measurements of a selection of primary side transformer AC signals ($V_1$, $V_2$, $V_3$); performing a second linear fit between the secondary side load voltages and the secondary side load currents to estimate a value of, or a value that is indicative of, at least one of the following transformer properties: the primary winding impedance ($Z_1$) and/or the impedance of one or more secondary windings ($Z_{12}$, $Z_{13}$).

In embodiments, the second linear fit is based on the relations

$$ \Delta V_2 = I_0 Z_1 + (Z_1 + Z_{sh1})\frac{I_2}{n_1} \tag{6} $$

$$ \Delta V_3 = I_0 Z_1 + (Z_1 + Z_{sh2})\frac{I_3}{n_2} \tag{7} $$

wherein the secondary side load currents ratio $I_2/I_3 = \sqrt{3}$ and the turn ratio $n_2/n_1 = \sqrt{3}$.

Embodiments may further comprises: measuring transformer voltages during variations of the transformer loads wherein the power transferred through the respective windings are proportional;

collecting, for said at least two different transformer loads, measurements of a selection of primary side transformer AC signals ($V_1$, $V_2$, $V_3$);
performing a third linear fit between secondary side load voltages (V2, V3) to estimate values of, or values indicative of, impedance change between the primary winding and one or more of the secondary windings.

In variants of this embodiment, the third linear fit is based on the relation

$$ \frac{V_3}{V_2} = \frac{n_1\big(n_1(V_1 - I_0 Z_1) - I_2(Z_1 + Z_{Zsh3})\big)}{n_2\big(n_1(V_1 - I_0 Z_1) - I_2(Z_1 + Z_{Zsh2})\big)} = \frac{n_1}{n_2} + \frac{Z_{sh2} - Z_{sh3}}{n_2(V_1 - I_0 Z_1)}\ I_2 + O[\,I_2\,]^2 \tag{8} $$

where $I_3 = \frac{n_2}{n_1}I_2$ has been used and the second equality comes from a series expansion in $I_2$.

In embodiments, the at least two secondary windings may comprise one Y-connected winding and one Δ-connected winding, and that performing a diagnosis comprises performing a ratio check between said secondary Y-connected winding and said secondary Δ-connected winding.

In variants of this embodiment, estimating a value of or a value that is indicative of one or more transformer properties may comprise performing a verification procedure to check that the relations $I_2/I_3$ and $V_3/V_2$ correspond to the nominal ratios $I_2/I_3 = \sqrt{3}$ and $V_3/V_2 = \sqrt{3}$.

Further embodiments provides a transformer diagnosis apparatus for diagnosing a transformer provided a transformer (100) having a primary side source winding and two secondary side load windings, using relations based on a transformer model in which effects of magnetizing currents in the transformer core, leakage inductances and effective resistances of the primary and secondary windings are taken into account, comprising: an input configured to receive signals indicative of AC signal measurements of a transformer; an output configured to deliver a value of or a value that is indicative of one or more transformer properties; a processor connected to the input and configured to perform the steps of selected embodiments of the methoddescribed described herein.

Further embodiments provide a transformer comprising a transformer diagnosis apparatus according to embodiments described herein.

Further embodiments provide a computer program for providing a diagnosis of a transformer, the computer program comprising computer program code portions which, when run on a computer implemented transformer diagnosis apparatus, causes the transformer diagnosis apparatus to perform method steps of any of claims

BRIEF DESCIPTION OF DRAWINGS

FIG 1 shows a circuit model of a three-winding transformer.

FIG 2A, 2B and 2C show graphs illustrating estimates and fittings of parameters for an HVDC unit with a transformer having two winding pairs.

Fig. 3 is a flow chart schematically illustrating methods disclosed herein.

DETAILED DESCIPTION

*Introduction*

Basic methods for on-line estimation and monitoring of TFQs (for example impedance, turn ratio, magnetizing current and power loss) of two-winding transformers are for example described in patent publications EP2466322B1/ US9322866B2. The present disclosure uses similar descriptions of transformer and circuit models as in these publications.

Embodiments described herein are devised to improve and/or to extend the capabilities of the transformer fundamental quantity (TFQ) monitoring methods. In particular, embodiments provide a transformer diagnosis method for three-winding HVDC transformers having equally loaded secondary sides.

In embodiments, a three-winding transformer is designed to produce two output voltages with a specific phase shift, terminal voltages and a turn ratio in each primary to secondary winding pair. The phase shift may for example be 30 degrees in the HVDC case. The fixed ratio between each turn-ratio can be used to bundle two load currents and this equivalent load current can then be fitted with the primary current as a one-dimensional linear fit, which is not dependent on the relative load variation between two secondary windings.

Further, for example HVDC transformers, designed to produce two output voltages with a phase shift of 30 degrees and to be loaded by the same amount, exhibits a specific relationship between the two secondary currents. Therefore, this additional relationship between secondary currents can be asserted and monitored by a linear fit thereby simplifying the fitting procedure to a one-dimensional fit to find the turn ratio and impedance.

Embodiment methods comprise measuring a transformer current and/or a transformer voltage during variations of the transformer loads, wherein the power transferred through the respective winding pair are proportional. Measurements of at least one current being indicative of the transformer load and/or measurements of at least one transformer AC signal are collected for at least two different transformer loads.

One or more of the measurements of transformer current or transformer voltage are in embodiments used to derive values of one or more transformer properties and/or values that are indicative of one or more transformer properties. Examples of such transformer properties are for example turns ratio, magnetization currents and/or impedances.

The one or more estimated or determined values may in embodiments then be used in performing a diagnosis of a transformer. For this purpose, the one or more values can be described in terms of a relation between said one or more values and said one or more further transformer properties.

Further transformer properties that can be monitored are for example temperature, combustible dissolved gas, and bushing capacitance.

The determination of a value describing or being indicative of a transformer property can be repeated by collecting further measurements at different loads, and by determining a new set of one or more value from which a new indication of a monitored property can be determined.

With the improved methods of embodiments herein values of transformer properties for three-winding HVDC transformers having equally loaded secondary sides can be determined. Diagnosis of transformers can be performed on-line.

EMBODIMENTS

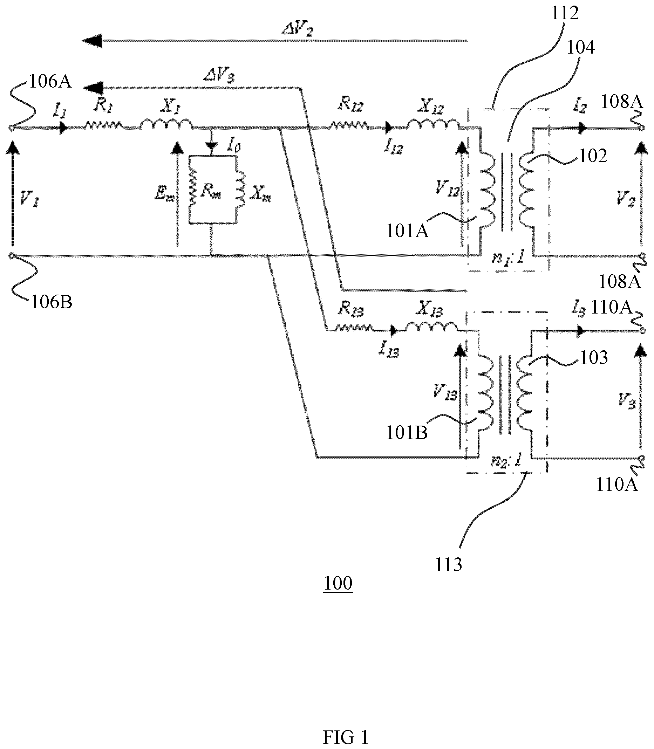

FIG 1 shows an equivalent circuit model of a single phase three-winding transformer upon which a transformer model is based. The transformer in the model comprises a primary winding 101A, 101B, and two secondary windings, here first secondary winding 102 and second secondary winding 103. A first part 101A of the primary winding supplies power to the first secondary winding 102 and makes up a first winding pair 112 marked with an intermittently drawn line in FIG 1. Similarly, a second part 101B of the primary winding supplies power to the second secondary winding 103 and makes up a second winding pair 113.

The transformer further comprises a transformer core 104. A first pair of winding terminals 106A, 106B are connected to the primary winding 101A,101B, respectively, and further pairs of winding terminals are connected to the respective secondary winding. As shown in FIG 1, a second pair of winding terminals 108A,108B are connected to the first secondary winding 102 and a third pair of winding terminals 110A, 110B are connected to the second secondary winding 103.

The voltage across the primary winding 101A,101B is denoted $V_1$, and the voltages across the respective secondary windings 102 and 103 are denoted $V_2$ and $V_3$ respectively. The current through the primary winding 101A, 101B is denoted $I_1$ and the currents through the two secondary windings 102 and 103 are denoted $I_2$ and $I_3$, respectively.

In the present description, the primary winding 101A, 101B is the winding which is fed by a source, and the secondary windings 102 and 103 are windings that deliver power to one or more loads. However, an opposite or other convention may be used to explain embodiments.

Other related expressions in the convention used herein are:

- the primary side or the source side is used for the side of the transformer having the primary windings being fed by a source;
- the secondary side or the load side for the side of the transformer having the secondary windings delivering power to one or more loads.

The single phase three-winding transformer equivalent circuit model comprises winding impedances, magnetizing impedance and voltage transformation ratio. The transformer model takes into account effects of magnetizing currents in the transformer core, leakage inductances and effective resistances of the primary and secondary windings. In the equivalent circuit model depicted in FIG 1, the impedances on the secondary side, i.e. the load side, have been reflected to the primary side, i.e. the source side.

Relations based on the transformer model as described in equations further below use the following notation for elements included in the equivalent circuit model shown in FIG 1:

- $R_1$: a resistance of the source winding, i.e. of the primary winding 101A, 101B;
- $X_1$: a leakage reactance of the source winding, i.e. of the primary winding 101A, 101B;
- $R_{12}$: a resistance of the first load winding, i.e. of the first secondary winding 102, reflected to the source side;
- $X_{12}$: a leakage reactance of the first load winding, i.e. of the first secondary winding 102, reflected to the source side;
- $R_{13}$: a resistance of the second load winding, i.e. of the second secondary winding 102, reflected to the source side;
- $X_{13}$: a leakage reactance of the second load winding, i.e. of the second secondary winding 102, reflected to the source side;
- $R_m$: an equivalent resistance representing the core losses, as seen from the source side;
- $X_m$: a reactance representing the core magnetization, as seen from the source side.
- $E_m$: the voltage across the equivalent shunt element $R_m$, $X_m$.
- $I_o$: the current through the equivalent shunt element $R_m$, $X_m$. The current $I_o$ represents the magnetizing current.

To express impedances, all R's and X's are combined to Z's by $Z=R+jX$, with the imaginary constant j.

The equivalent circuit model reflects the effects of voltage drop in the transformer caused by leakage magnetic flux and of power losses in the windings. The effects causing such voltage drop and power loss are illustrated by including, in the equivalent circuit model, a resistance $R_1$ of the primary winding, a leakage reactance $X_1$ of the primary winding and a respective resistance $R_{12}$ and $R_{13}$ of each respective secondary winding. The resistances represent real power loss, whereas reactance represent apparent power loss. The equivalent circuit model further comprises leakage reactances $X_{12}$ and $X_{13}$ of each respective secondary winding, a resistance $R_m$ representing the core losses and a reactance $X_m$

representing the core magnetization. As mentioned, these resistances and reactances, and thus also the impedances of the two secondary windings are in the depicted equivalent circuit model reflected to and shown as seen from the primary side, i.e. from the source side.

$R_1$ and $X_1$ are connected in series with the primary winding 101A,101B, i.e. the source winding. In a first order model of a transformer, $R_{12}$, $R_{13}$ and $X_{12}$, $X_{13}$ would be seen connected in series with the respective secondary winding. In the equivalent circuit model shown in FIG 1, however, $R_{12}$, $R_{13}$ and $X_{12}$, $X_{13}$ have been transposed from the secondary to the primary side, i.e. from the load side to the source side. Thus in FIG 1, $R_{12}$ and $X_{12}$, are connected in series with the part 101A of the primary winding that supplies power to the first secondary winding 102. Similarly, $R_{13}$ and $X_{13}$ are connected in series with the part 101B of the primary winding that supplies power to the second secondary winding 103. $R_m$ and $X_m$ are connected in parallel and form an equivalent shunt element which is connected in parallel with the primary winding.

The equivalent current through the equivalent shunt element is denoted $I_o$, whereas the voltage across the equivalent shunt element is denoted $E_m$. The current $I_o$ represents the magnetizing current.

In embodiments of a transformer model, the expressions below relate to the voltage drop across the transformer for each winding pair 112,113, the respective voltage drop being denoted $\Delta V_2$ and $\Delta V_3$. Each voltage drop can be derived by applying the Kirchhoff's voltage law, using the relationships $V_2 n_1 = V_{12}$ and $V_3 n_2 = V_{13}$.

$$\Delta V_2 = V_1 - V_{12} = I_0 Z_1 + \frac{I_3}{n_2} Z_1 + \frac{I_2}{n_1} \overbrace{(Z_{12} + Z_1)}^{Z_{sh1}}$$

$$\Delta V_2 = I_0 Z_1 + \frac{I_3}{n_2} Z_1 + \frac{I_2}{n_1} Z_{sh1} \qquad (1)$$

$$\Delta V_3 = V_1 - V_{13} = I_0 Z_1 + \frac{I_2}{n_1} Z_1 + \frac{I_3}{n_2} \overbrace{(Z_{13} + Z_1)}^{Z_{sh2}}$$

$$\Delta V_3 = I_0 Z_1 + \frac{I_2}{n_1} Z_1 + \frac{I_3}{n_2} Z_{sh2} \qquad (2)$$

In equation (1) and (2), $Z_{sh1}$ and $Z_{sh2}$ are the short-circuit impedance of each winding pair 112,113, which in principle could be estimated from a two-dimensional linear fit. The primary current $I_1$ and the secondary currents (i.e. load currents) $I_2$ and $I_3$ are related as shown in equation (3).

$$I_1 = I_0 + \frac{I_2}{n_1} + \frac{I_3}{n_2} \qquad (3)$$

As mentioned, in principle, a two-dimensional linear fit could be used to estimate the turn ratios and the impedances. However, the accuracy of the two-dimensional fit is dependent on the relative load variation between $I_2$ and $I_3$. This means that with equally loaded secondary windings like in HVDC units a two-dimensional linear fit cannot be used to find the turn ratios and the impedances. In other words, if the currents are always proportional to each other there is no way to find their respective coefficients by a fit of equation 3 in a linear regression analysis.

To solve this problem, embodiments herein take advantage of the fact that the two secondary windings have a fixed turn ratio with respect to a common primary winding.

In the relation $n_2 = a \cdot n_1$, 'a' is the open-circuit voltage ratio between the secondary winding voltages $V_2/V_3$ shown in Fig. 1, i.e. $V_2/V_3 = a$ and hence $I_3/I_2 = a$. Used in equation (3) this will result in equation (4):

$$I_1 = I_0 + \frac{1}{n_1} \overbrace{(I_2 + \frac{I_3}{a})}^{I} \qquad (4)$$

In the case of HVDC transformers, two secondary windings are designed to provide the same line-to-line voltage with a phase shift of 30°, which is achieved by $\Delta$ and Y configurations of each winding pair. This requires that the relationship between the two turn ratios is $a = 1/\sqrt{3}$, i.e. $n_2/n_1 = 1/\sqrt{3}$, $V_2/V_3 = 1/\sqrt{3}$ and $I_2/I_3 = \sqrt{3}$. Used in equation (4) this will result in the equations:

$$I_1 = I_0 + \frac{1}{n_1}(I_2 + \sqrt{3}I_3) \qquad (5)$$

$$I_1 = I_0 + \frac{1}{n_1}2\sqrt{3}\,I_3 \qquad (5.1)$$

In these equations (5) and (5.1) $n_1$ represents the turn ratio of the primary winding to the Y-connected secondary winding. The turn ratio $n_2$ (not present in equations (5) and (5.1)) represents the turn ratio of the primary winding to the $\Delta$-connected secondary winding. As described above, the turn ratios $n_1$ and $n_2$ are proportional. The equivalent load current, i.e. the sum of the respective load currents on the secondary side as reflected on the primary source side $I_{12}$ and $I_{13}$ can be expressed as $I_{12}+I_{13}= I_2/n_1+I_3/n_2=I_2+I_3/a$.

In embodiments, a one-dimensional linear fit is performed between equivalent load current $(I_2+I_3/a)$ and the primary current $I_1$ to estimate the values of, or a value that is indicative of, at least one of the transformer properties turn ratio $n_1$ and the magnetizing current $I_0$, and thereby also the turn ratio $n_2$. For a value that is indicative of one or more of these transformer properties, the relation may for example be linear and such that the indicative value is proportional to the actual value, or it may follow another linear or non-linear relationship.

While the above describes single phase application, the reasoning is also applicable in embodiments for three phase applications. Embodiments of the transformer model in three phase applications take into account that the HVDC transformers have another special feature, namely that the two secondary windings, which is Y-connected and $\Delta$-connected (delta-connected) respectively, are always equally loaded, i.e., with the same line-to-line voltage secondary winding currents are related by $I_2 = \sqrt{3}I_3$, where $I_2$ is current in the Y-connected winding current and $I_3$ is current in the $\Delta$-connected (delta-connected) winding.

The combined conditions in the case of HVDC transformers are thus taken account of in embodiments of the transformer model, i.e. that:

- firstly, two secondary windings are designed to provide the same line-to-line voltage with a phase shift of 30°, which is achieved by $\Delta$ and Y configurations of each winding pair; and
- secondly, that the two secondary windings, which as mentioned are Y-connected and $\Delta$-connected (delta-connected) respectively, are always equally loaded.

As is clear from above, these conditions thus entails that the secondary side load currents $I_2$ and $I_3$, and the secondary side load voltages $V_2$ and $V_3$ are proportional by the specific factor $\sqrt{3}$, i.e. $I_2/I_3 = \sqrt{3}$ and $V_3/V_2= \sqrt{3}$.

This fact is in embodiments utilized to simplify and alleviate the issue in prior art with inferior, or impossible, two-dimensional fit for impedance estimation using equation (1) and (2), as HVDC transformers are equally loaded without a relative variation between $I_2$ and $I_3$. With the above relation between the secondary currents $I_2$ and $I_3$, i.e. that the secondary side load currents $I_2/I_3 = \sqrt{3}$ and that the turn ratios $n_2/n_1=1/\sqrt{3}$, equations (1) and (2) can be re-written to read:

$$\Delta V_2 = I_0 Z_1 + (Z_1 + Z_{sh1})\frac{I_2}{\sqrt{3}n_2} \qquad (6)$$

$$\Delta V_3 = I_0 Z_1 + (Z_1 + Z_{sh2})\frac{\sqrt{3}\,I_3}{n_1} \qquad (7)$$

In embodiments directed to HVDC units, a verification procedure is made to ascertain the relationship between the Y-connected winding and the $\Delta$-connected (delta-connected) winding voltages and currents, which as explained above should nominally be $I_2/I_3= \sqrt{3}$ and $V_3/V_2= \sqrt{3}$. That is, one of the ratios $I_2/I_3$ and $V_2/V_3$, is calculated and it is checked that that the calculated ratio is as expected by the other ratio. In embodiments, values of, or values indicative of, the absolute impedances are estimated from equation (6) and (7).

The voltage ratio $V_2/V_3$ ($V_3/V_2$) should be constant but if the winding impedances in the two secondary windings differ, it will become load dependent as shown by the following equation (8):

$$\frac{V_3}{V_2} = \frac{n_1\big(n_1(V_1-I_0Z_1) - I_2(Z_1+Z_{sh3})\big)}{n_2\big(n_1(V_1-I_0Z_1) - I_2(Z_1+Z_{sh2})\big)} = \frac{n_1}{n_2} + \frac{Z_{sh2}-Z_{sh3}}{n_2(V_1-I_0Z_1)} I_2 + O\big[I_2\big]^2 \qquad (8)$$

where $I_3 = \frac{n_2}{n_1} I_2$ has been used and the second equality comes from a series expansion in $I_2$.

Equation (8) is based on the first steps equations (1) and (2) rendering $DV_2 = V_1 - n_1 V_2$ or $V_2 = 1/n1 (V_1 - DV_2)$, then using equations (6) for $DV_2$. A similar operation is done for $V_3$ using equation (7). A number of simplifications render the first part of equation (8). The series expansion is added to be able to observe the $I_2$ dependence.

Thus any difference in the secondary winding impedances will be reflected by a secondary voltage ratio that is dependent on load. Further it may be noted that difference in secondary winding impedances will result in a larger and load dependent DC voltage ripple for HVDC. Thus, a HVDC transformer must be designed so that these impedances are as equal as possible. Therefore, a linear fit between secondary side load voltages $V_3 = \sqrt{3}V_2$ ), comprised in embodiments, gives a further improved and more sensitive indication of a difference between the impedances influencing the two secondary voltages $V_2$ and $V_3$. Any load dependence of the ratio $V_2/V_3$ would namely indicate that $Z_{sh2}$ is different from $Z_{sh3}$, which is a check of how well the design requirements are fulfilled. Therefore, in embodiments, the secondary voltage ratio as a function of load is monitored, utilizing the fact that any deviation from a constant value is indicative of an impedance mismatch.

The underlying idea is to make sure that the $V_2$ and $V_3$ has a perfect linear relationship, otherwise equation (8) tells that it differs at a rate of impedance difference (Zsh2-Zsh3). In embodiments, a linear fit is made between secondary side voltages to ascertain the linear relation ( $V_3 = \sqrt{3}V_2$ ), which is, based on equation (8), an estimated value or a value indicative of impedance change between the primary winding and one or more of the secondary windings.

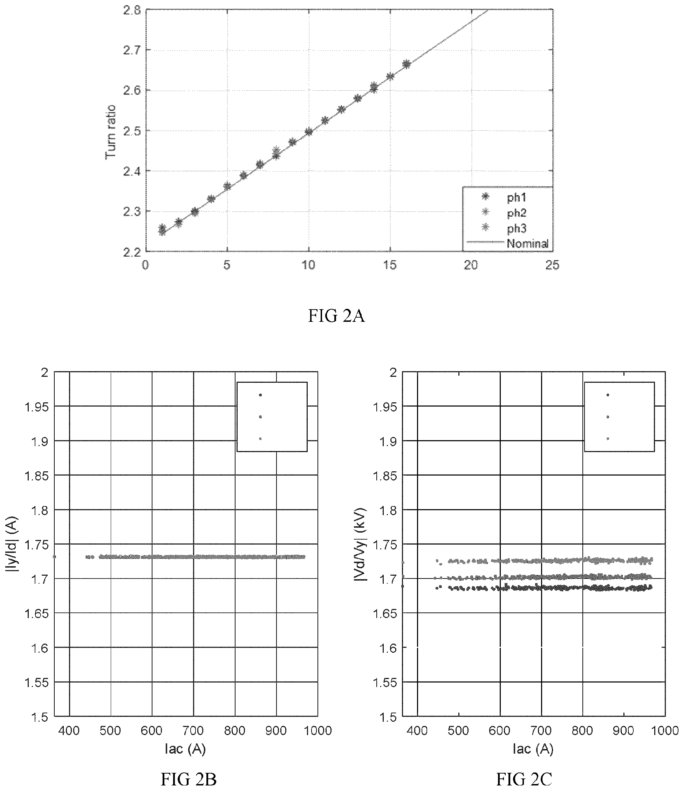

FIG 2A, 2B and 2C show graphs illustrating estimates and fittings of parameters for an HVDC unit with a transformer having two winding pairs based on the above-described relations.

Embodiments of transformers may have a plurality of connection points, so called taps, provided to enable selection of different turn ratios. The turn ratio between the primary winding and the Y winding, $n_1$, of a HVDC unit can be estimated at each tap based on equation (5). FIG 2A shows turn ratio between the primary winding and the Y winding (n1) of a HVDC unit, estimated at each of a plurality of taps based on eq. (5). Nominal value is shown as a straight line.

FIG 2B shows the secondary side winding current fit of the Y-connected winding versus the $\Delta$-connected winding current, i.e. Y(A) vs Id(A), of a three-phase bank of HVDC transformers. FIG 2C shows the $\Delta$-connected winding voltage versus the Y-connected winding voltage, i.e. Vd/Vy as a function of I1, Id or Iy.

Unlike fitting performed based on eq. (5) - (7), the relation between Y and $\Delta$-winding currents and voltages must hold irrespective of the tap position, and any deviation in load current relation could be a sign of a transformer issue or reflect the fact that two HVDC converter legs are not loaded symmetrically and that the voltage relationship could be disrupted by change in impedance of one winding pair.

Thus, to summarize, in accordance with embodiments HVDC three-winding transformers can be monitored in the same way a as a two-winding transformer. With the addition of ratio check between secondary Y and $\Delta$-windings, problems related to individual winding pairs may be revealed.

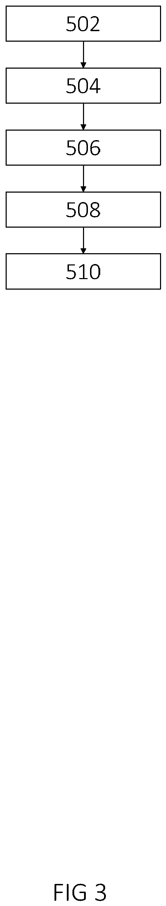

FIG 3 is a flow chart schematically illustrating an overview of embodiments of a transformer diagnosis method for a transformer (100) provided with two equally loaded secondary windings of two winding pairs, wherein the transformer model is applied. Method steps are in embodiments performed in a transformer diagnosis apparatus comprising a processor.

Embodiments of a transformer diagnosis method for a transformer (100) having a primary side source winding and two secondary side load windings, the method using relations based on a transformer model in which effects of magnetizing currents in the transformer core, leakage inductances and effective resistances of the primary and secondary windings are taken into account comprise one or more of the following steps.

502: Using a transformer model of a three-winding transformer (100) having a primary side and a secondary side, said transformer being provided with two equally loaded secondary windings (102,103) configured to provide a phase shift of 30° for same line-to-line voltages.

504: Measuring transformer currents during variations of the transformer loads wherein the power transferred through the respective windings are proportional.

506: Collecting, for at least two different transformer loads, measurements of a selection of primary side currents ($I_1$, $I_2$, $I_3$) being indicative of the transformer load.

508: Performing, by means of relations based on said transformer model, a first one-dimensional linear fit between equivalent load current ($I_2+I_3/a$) and the primary current ($I_1$) to estimate the value of, or a value that is indicative of, at least one of the following transformer properties: at least one turn ratio ($n_1,n_2$) and the magnetizing current ($I_0$).

510: Possibly analyzing the results of the estimations to determine or assess the status of the transformer.

In embodiments, the method is performed in a transformer diagnosis apparatus comprising a processor.

In embodiments, load is imposed on the secondary windings and is varied such that the amounts of power transferred through the respective winding pair are proportional to each other in order to enable the measurement under the desired power transfer circumstances. In other embodiments, the load under normal operation is known to have this proportionality and measurements are collected under varying conditions for the purpose of the analysis of transformer status.

In embodiments, the first linear fit is based on the relations

$$I_1 = I_0 + \frac{1}{n_1}(I_2 + \sqrt{3}I_3) \qquad\qquad (5)$$

$$I_1 = I_0 + \frac{1}{n_1}2\sqrt{3}\ I_3 \qquad\qquad (5.1)$$

the turn ratios ($n_1$, $n_2$) having a proportional relation of $n_1/n_2 = \sqrt{3}$ .

In embodiments, the method further comprises:

measuring transformer voltages during variations of the transformer loads wherein the power transferred through the respective windings are proportional;

collecting, for said at least two different transformer loads, measurements of a selection of primary side transformer AC signals ($V_1$, $V_2$, $V_3$);

performing a second linear fit between the secondary side load voltages and the secondary side load currents to estimate a value of, or a value that is indicative of, at least one of the following transformer properties: the primary winding impedance ($Z_1$) and/or the impedance of one or more secondary windings ($Z_{12}$, $Z_{13}$). In such embodiments, the second linear fit is preferably based on the relations

$$\Delta V_2 = I_0 Z_1 + (Z_1 + Z_{sh1})\frac{I_2}{n_1} \qquad (6)$$

$$\Delta V_3 = I_0 Z_1 + (Z_1 + Z_{sh2})\frac{I_3}{n_2} \qquad (7)$$

wherein the secondary side load currents ratio $I_2/I_3 = \sqrt{3}$ and the turn ratio $n_2/n_1 = \sqrt{3}$.

Further embodiments of the above variants, may comprise:

measuring transformer voltages during variations of the transformer loads wherein the power transferred through the respective windings are proportional;

collecting, for said at least two different transformer loads, measurements of a selection of primary side transformer AC signals ($V_1$, $V_2$, $V_3$);

performing a third linear fit between secondary side load voltages (V2, V3) to estimate values of, or values indicative of, impedance change between the primary winding and one or more of the secondary windings. In such embodiments, the third linear fit may be based on the relation

$$\frac{V_3}{V_2} = \frac{n_1\big(n_1(V_1 - I_0 Z_1) - I_2(Z_1 + Z_{Zsh3})\big)}{n_2\big(n_1(V_1 - I_0 Z_1) - I_2(Z_1 + Z_{Zsh2})\big)} = \frac{n_1}{n_2} + \frac{Z_{sh2} - Z_{sh3}}{n_2(V_1 - I_0 Z_1)}\ I_2 + O[\,I_2]^2 \quad (8)$$

where $I_3 = \frac{n_2}{n_1}I_2$ has been used and the second equality comes from a series expansion in $I_2$.

Embodiments of the above variants may further comprise that at least two secondary windings comprise one Y-connected winding and one Δ-connected winding, and that performing a diagnosis comprises performing a ratio check between said secondary Y-connected winding and said secondary Δ-connected winding.

The model is in embodiments based on that said equally loaded secondary windings maintain a constant ratio between the secondary voltages.

The at least two secondary windings comprise, in embodiments, one Y-connected winding and one Δ-connected winding, and that performing a diagnosis comprises performing a ratio check between said secondary Y-connected winding and said secondary Δ-connected winding.

Embodiments of estimating a value of or a value that is indicative of one or more transformer properties may comprise performing a verification procedure to check that the relations $I_2/I_3$ and $V_3/V_2$ correspond to the nominal ratios $I_2/I_3 = \sqrt{3}$ and $V_3/V_2 = \sqrt{3}$.

Embodiments of a transformer diagnosis apparatus for diagnosing a transformer provided a transformer (100) having a primary side source winding and two secondary side load windings, using relations based on a transformer model in which effects of magnetizing currents in the transformer core, leakage inductances and effective resistances of the primary and secondary windings are taken into account, comprises:

- an input configured to receive signals indicative of AC signal measurements of a transformer;
- an output configured to deliver a value of or a value that is indicative of one or more transformer properties;
- a processor connected to the input and configured to perform the steps of method embodiments as described above.

Further, a transformer is provided comprising a transformer diagnosis apparatus according to the preceding description.

A computer program is provided for providing a diagnosis of a transformer as described above, the computer program comprising computer program code portions which, when run on a computer implemented transformer diagnosis apparatus, causes the transformer diagnosis apparatus to perform method steps of embodiments in accordance with the above description.

Different embodiments are configured with different combinations of the above features.

**Claims**

1. A transformer diagnosis method for a transformer having a primary side source winding and two secondary side load windings, the method using relations based on a transformer model in which effects of magnetizing currents in the transformer core, leakage inductances and effective resistances of the primary and secondary windings are taken into account,

   **characterized in**

   using (502) a transformer model of a three-winding transformer (100) having a primary side and a secondary side, said transformer being provided with two equally loaded secondary windings (102,103) configured to provide a phase shift of 30° for same line-to-line voltages;

   measuring (504) transformer currents during variations of the transformer loads wherein the power transferred through the respective windings are proportional;

   collecting (506), for at least two different transformer loads, measurements of a selection of primary side currents ($I_1$, $I_2$, $I_3$) being indicative of the transformer load, preferably ($I_1$ and $I_2$) or ($I_1$ and $I_3$);

   performing (508), by means of relations based on said transformer model, a first one-dimensional linear fit between equivalent load current ($I_2$+$I_3$/a) and the primary current ($I_1$) to estimate the value of, or a value that is indicative of, at least one of the following transformer properties: at least one turn ratio ($n_1$,$n_2$) and the magnetizing current ($I_0$).

2. The method of claim 1, being performed in a transformer diagnosis apparatus comprising a processor.

3. The method of claim 1 or 2, wherein load is imposed on the secondary windings and is varied such that the amounts of power transferred through the respective winding pair are proportional to each other in order to enable the measurement under the desired power transfer circumstances.

4. The method of any of the preceding claims, wherein said first linear fit is based on the relations

$$I_1 = I_0 + \frac{1}{n_1}(I_2 + \sqrt{3}I_3) \qquad\qquad (5)$$

$$I_1 = I_0 + \frac{1}{n_1} 2\sqrt{3}\ I_3 \qquad\qquad (5.1)$$

the turn ratios ($n_1$,$n_2$) having a proportional relation of $n_1/n_2 = \sqrt{3}$ .

5. The method of any of the preceding claims, further comprising:

measuring transformer voltages during variations of the transformer loads wherein the power transferred through the respective windings are proportional;
collecting, for said at least two different transformer loads, measurements of a selection of primary side transformer AC signals ($V_1$, $V_2$, $V_3$);
performing a second linear fit between the secondary side load voltages and the secondary side load currents to estimate a value of, or a value that is indicative of, at least one of the following transformer properties: the primary winding impedance ($Z_1$) and/or the impedance of one or more secondary windings ($Z_{12}$, $Z_{13}$).

6. The method of the preceding claim, wherein said second linear fit is based on the relations

$$\Delta V_2 \ = \ I_0 Z_1 + (Z_1 + Z_{sh1})\frac{I_2}{n_1} \qquad (6)$$

$$\Delta V_3 \ = \ I_0 Z_1 + (Z_1 + Z_{sh2})\frac{I_3}{n_2} \qquad (7)$$

wherein the secondary side load currents ratio $I_2/I_3 = \sqrt{3}$ and the turn ratio $n_2/n_1 = \sqrt{3}$.

7. The method of any of the preceding claims, further comprising:

measuring transformer voltages during variations of the transformer loads wherein the power transferred through the respective windings are proportional;
collecting, for said at least two different transformer loads, measurements of a selection of primary side transformer AC signals ($V_1$, $V_2$, $V_3$);
performing a third linear fit between secondary side load voltages (V2, V3) to estimate values of, or values indicative of, impedance change between the primary winding and one or more of the secondary windings.

8. The method of the preceding claim, wherein said third linear fit is based on the relation

$$\frac{V_3}{V_2} = \frac{n_1\big(n_1(V_1 - I_0 Z_1) - I_2(Z_1 + Z_{Zsh3})\big)}{n_2\big(n_1(V_1 - I_0 Z_1) - I_2(Z_1 + Z_{Zsh2})\big)} = \frac{n_1}{n_2} + \frac{Z_{sh2} - Z_{sh3}}{n_2(V_1 - I_0 Z_1)} I_2 + O[\,I_2\,]^2 \quad (8)$$

where $I_3 = \frac{n_2}{n_1} I_2$ has been used and the second equality comes from a series expansion in $I_2$.

9. The method of any of the preceding claims, wherein said at least two secondary windings comprises one Y-connected winding and one $\Delta$-connected winding, and that performing a diagnosis comprises performing a ratio check between said secondary Y-connected winding and said secondary $\Delta$-connected winding.

10. The method of any of the preceding claims, wherein estimating a value of or a value that is indicative of one or more transformer properties comprises performing a verification procedure to check that the relations $I_2/I_3$ and $V_3/V_2$ correspond to the nominal ratios $I_2/I_3 = \sqrt{3}$ and $V_3/V_2 = \sqrt{3}$.

11. A transformer diagnosis apparatus for diagnosing a transformer provided a transformer (100) having a primary side source winding and two secondary side load windings, using relations based on a transformer model in which effects of magnetizing currents in the transformer core, leakage inductances and effective resistances of the primary and secondary windings are taken into account, comprising:

- an input configured to receive signals indicative of AC signal measurements of a transformer,
- an output configured to deliver a value of or a value that is indicative of one or more transformer properties;
- a processor connected to the input and configured to perform the steps of method claims 1-10.

12. A transformer comprising a transformer diagnosis apparatus according to claim 11.

13. A computer program for providing a diagnosis of a transformer, the computer program comprising computer program code portions which, when run on a computer implemented transformer diagnosis apparatus, causes the transformer diagnosis apparatus to perform method steps of any of claims 1-10.

FIG 1

FIG 2A

FIG 2B

FIG 2C

```
┌─────────────────────┐
│         502         │
└─────────────────────┘
           │
           ▼
┌─────────────────────┐
│         504         │
└─────────────────────┘
           │
           ▼
┌─────────────────────┐
│         506         │
└─────────────────────┘
           │
           ▼
┌─────────────────────┐
│         508         │
└─────────────────────┘
           │
           ▼
┌─────────────────────┐
│         510         │
└─────────────────────┘
```

FIG 3

Europäisches
Patentamt
European
Patent Office
Office européen
des brevets

**EUROPEAN SEARCH REPORT**

**Application Number**

**EP 24 21 9592**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2013/282312 A1 (ABEYWICKRAMA NILANGA [SE] ET AL) 24 October 2013 (2013-10-24) * paragraphs [0035] - [0124]; claims 1-16; figures 1-9 * | 1-13 | INV. G01R31/62 |
| A | EP 2 917 746 B1 (BOMBARDIER TRANSP GMBH [DE]) 24 February 2021 (2021-02-24) * paragraphs [0073] - [0085]; claims 1-15; figures 1-2 * | 1-13 | |
| A | US 11 422 175 B2 (STATE GRID JIANGSU ELECTRIC POWER CO LTD [CN] ET AL.) 23 August 2022 (2022-08-23) * columns 3-8; claims 1-5; figures 1-2 * | 1-13 | |
| A | EP 2 474 832 B1 (GEN ELECTRIC [US]) 13 June 2018 (2018-06-13) * paragraphs [0009] - [0026]; claims 1-10; figures 1-4 * | 1-13 | |

TECHNICAL FIELDS
SEARCHED (IPC)

G01R

The present search report has been drawn up for all claims

| Place of search | Date of completion of the search | Examiner |
|---|---|---|
| Munich | 23 May 2025 | Bilzer, Claus |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

      .................................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 21 9592

This annex lists the patent family members relating to the patent documents cited in  the above-mentioned European search report.
The members are as contained in the European Patent Office EDP file on
The European Patent Office is in no way liable for these particulars which are merely given for the purpose of information.

23-05-2025

| Patent document cited in search report | | Publication date | Patent family member(s) | | Publication date |
|---|---|---|---|---|---|
| US 2013282312 | A1 | 24-10-2013 | BR | 112013014847 A2 | 18-10-2016 |
| | | | CN | 103328990 A | 25-09-2013 |
| | | | EP | 2466322 A1 | 20-06-2012 |
| | | | ES | 2439279 T3 | 22-01-2014 |
| | | | KR | 20130113504 A | 15-10-2013 |
| | | | PL | 2466322 T3 | 30-04-2014 |
| | | | US | 2013282312 A1 | 24-10-2013 |
| | | | WO | 2012079906 A1 | 21-06-2012 |
| EP 2917746 | B1 | 24-02-2021 | DE | 102012220474 A1 | 15-05-2014 |
| | | | EP | 2917746 A1 | 16-09-2015 |
| | | | RU | 2015121807 A | 10-01-2017 |
| | | | WO | 2014072444 A1 | 15-05-2014 |
| US 11422175 | B2 | 23-08-2022 | CN | 111638408 A | 08-09-2020 |
| | | | CN | 112255490 A | 22-01-2021 |
| | | | US | 2021364562 A1 | 25-11-2021 |
| EP 2474832 | B1 | 13-06-2018 | EP | 2474832 A2 | 11-07-2012 |
| | | | JP | 5973716 B2 | 23-08-2016 |
| | | | JP | 2012129527 A | 05-07-2012 |
| | | | US | 2012158325 A1 | 21-06-2012 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100188240 A
- EP 2466322 B1
- US 9322866 B2